# EUROPEAN PATENT SPECIFICATION

(11) **EP 4 195 884 B1**
(45) Date of publication and mention of the grant of the patent: **04.02.2026**
(21) Application number: 21213570.1
(22) Date of filing: 09.12.2021
(51) Int. Cl.: H05K 1/14, G06F 1/18, H05K 5/02, H05K 7/02, H05K 7/14

(54) **POWER SUPPLY WITH DETACHABLE COMMUNICATION MODULE**
STROMVERSORGUNG MIT ABNEHMBAREM KOMMUNIKATIONSMODUL
ALIMENTATION ÉLECTRIQUE AVEC UN MODULE DE COMMUNICATION AMOVIBLE

(43) Date of publication of application: 14.06.2023
(73) Proprietor: Cotek Electronic Ind. Co., Ltd., 33548 Taoyuan City (TW)
(72) Inventor: Wu, Chun-Wei, 33548 Taoyuan City (TW); Wei, Ta-Chang, 33548 Taoyuan City (TW); Tsai, Chung-Liang, 33548 Taoyuan City (TW); Yeh, Shou-Cheng, 33548 Taoyuan City (TW)
(74) Representative: 2K Patentanwälte Blasberg Kewitz & Reichel

(56) References cited:
- US-A- 5 113 317
- US-A1- 2007 197 056
- US-A1- 2016 197 504

## Description

### FIELD OF THE INVENTION

The invention relates to a power supply, and more particularly to a power supply with which a user is capable of replacing a communication module by oneself.

### BACKGROUND OF THE INVENTION

With the development of technology, the current power supply has a wide range of applications, and users have to select the corresponding output interface based on their own needs. However, the output interface type of the commercially available power supply is fixed, and a single power supply can only be equipped with a single type of interface; as a result, users can only use the communication type of the output interface on the power supply with a corresponding external connector. Since the output interface of the power supply cannot be changed according to a user's own needs, the user has to rely on external connectors for switching, which is inconvenient.

In addition, the communication interface in the existing power supply adopts a fixed design, in case the communication interface is damaged, the user will be unable to replace the communication interface, and must send the entire power supply back to the original manufacturer for repair.

On the other hand, the existing power supply pursues the characteristic of small size, but there are many electronic components inside the power supply; therefore, physical wires are usually used for connecting the output interface with the power supply main board. However, physical wires occupy the internal space of the power supply during assembly, in case locations for arranging the wires are not properly laid out, it is easy to cause poor heat dissipation inside the power supply. According to this, although the existing communication interface can be vertically installed on the main board in the form of an adapter card and electrically connected with the main board, the conventional communication interface card still cannot be replaced by the user.

US 2016/197504 A1 discloses an uninterruptible power supply (UPS), which comprises a battery within a battery housing, and the battery housing has a first connector mounted on the battery housing. The UPS further includes a housing having a battery compartment for removably containing the battery housing of the battery, wherein the housing has a second connector mounted within the battery compartment. The UPS further includes a first input configured to receive input power from an AC power source, and at least one output configured to provide output AC power derived from the input power in a first mode of operation and configured to provide output power derived from the at least one battery module in a second mode of operation.

US2007/197056 A1 discloses a computer system including a first circuit board and a second circuit board which is detachably coupled to the first circuit board via an I/O connector. When coupled together, the main board and the I/O card are positioned within a same plane. In the event that the first circuit board or the second circuit board needs to be modified, the two circuit boards can be detached from each other and after the modification, the two circuit boards can be coupled together again with the same connector to resume the functions of the computer system. A socket for precisely guiding and positioning the second circuit board and configured to fix its position in an assembled state is not disclosed.

US 5 113 317 A discloses a three part card guide for attachment to a host circuit card comprising opposing guide rails to receive transverse edges of an auxiliary circuit card. The guide rails attach to either end of a connector support which holds a first electrical connector and an auxiliary circuit card may be slid between the guide rails so that a second electrical connector along its rearward edge engages the first electrical connector. The guide rails and connector support assembly have hooks, to attach them to the host circuit card, which may be engaged with longitudinal motion of the assembly. The electrical connector, when attached to the host card through the connector support, prevents such longitudinal motion, locking the assembly in place.

### SUMMARY OF THE INVENTION

It is an object of the invention is to provide a power supply including a communication interface configured to be replaced by users easily and to be precisely and stably positioned in an assembled state.

This problem is solved by a power supply as claimed in claim 1. Further advantageous embodiments are the subject-matter of the dependent claims.

Through the foregoing implementation of the invention, compared with the prior art, the invention has the following features: the power supply of the invention comprises the sub-board, and the sub-board is provided with the first connector, when the communication module is inserted, the electrical connection part is connected with the first interface, thereby generating an electrical connection relationship with the main board via the sub-board. When a user intends to take out the communication module, the electrical connection part is detached from the first interface, and the communication module is completely separated from the sub-board, thereby the communication module of the power supply of the invention can be replaced by the user according to requirements.

### BRIEF DESCRIPTION OF THE DRAWINGS

FIG. 1 is a perspective structural view of an embodiment of the invention.
FIG. 2 is an exploded structural view of an embodiment of the invention.
FIG. 3 is a first exploded structural view of partial components of an embodiment of the invention.
FIG. 4 is a second exploded structural view of partial components of an embodiment of the invention.
FIG. 5 is a first top view of a cross-sectional structure of an embodiment of the invention.
FIG. 6 is a second top view of a cross-sectional structure of an embodiment of the invention.
FIG. 7 is a side view of a partial structure of an embodiment of the invention.
FIG. 8 is a perspective view of a communication module of another embodiment of the invention.
FIG. 9 is a perspective view of the communication module of yet another embodiment of the invention.

### DETAILED DESCRIPTION OF THE PREFERRED EMBODIMENTS

The detailed description and technical content of the invention are described below with reference to the accompanying drawings.

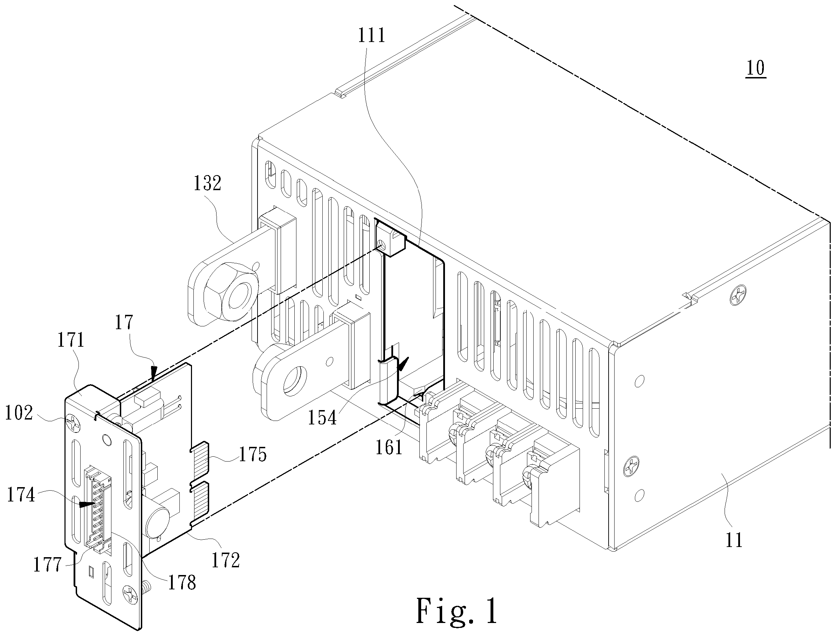

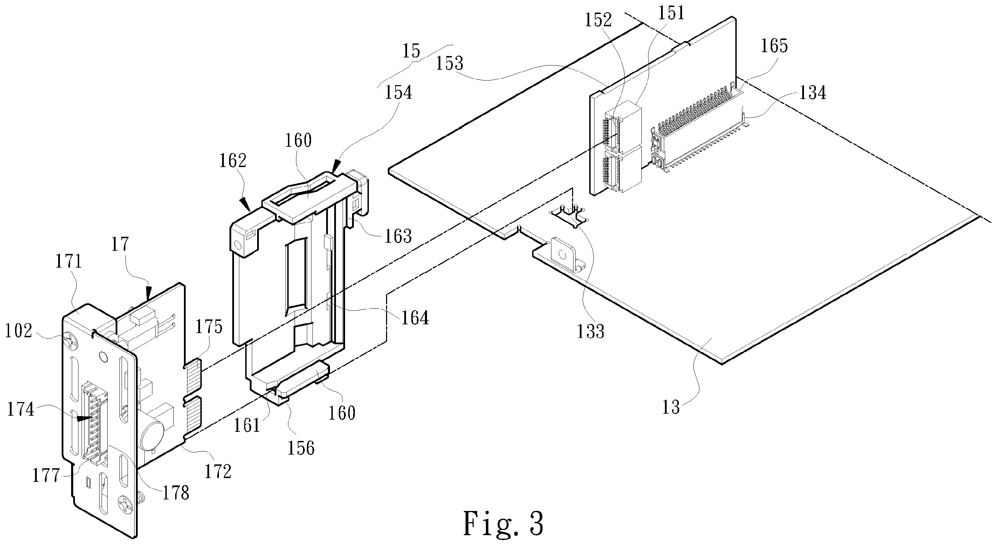

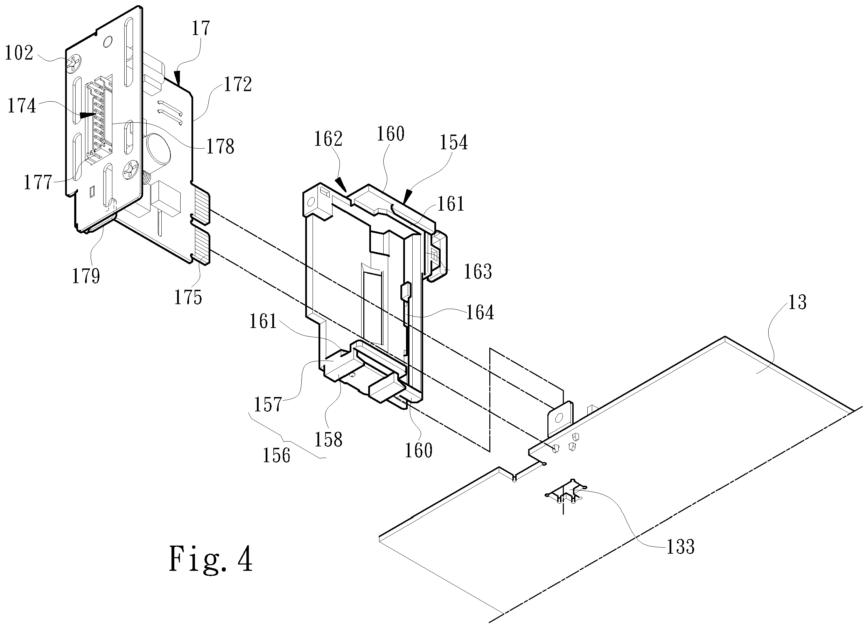

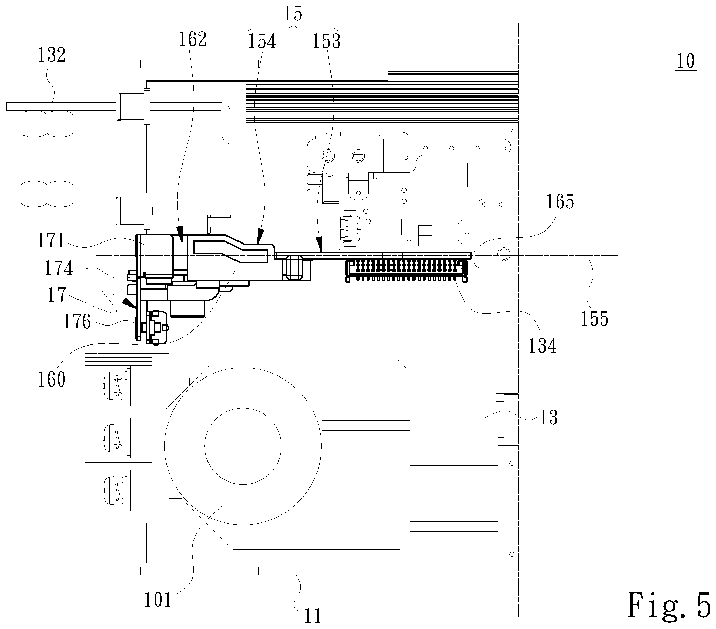

Referring to Figs. 1 to 5, the invention provides a power supply 10, and the power supply 10 comprises a casing 11, a main board 13, a sub-board 15 and a communication module 17. The casing 11 is used to protect a plurality of electronic components 101 inside the power supply 10, and the casing 11 comprises a port 111. The port 111 is formed by one side plate of the casing 11. The main board 13 is placed in the casing 11 and provided for disposing the electronic components 101. The main board 13 comprises a power conversion circuit electrically connected to the electronic components 101. The power conversion circuit can be a conductive layer of the main board 13. The power conversion circuit receives an electric power from at least one of the electronic components 101 and transmits the electric power to at least another one of electronic components 101. The power conversion circuit comprises at least one electrical connection terminal 132, which can be implemented in a form of a connecting pin or a connecting port to be used for receiving or transmitting electric power. In addition, the sub-board 15 is disposed on the main board 13 to electrically connect to the power conversion circuit. The sub-board 15 is provided with at least one first connector 151, wherein a first interface 152 of the first connector 151 directly faces the port 111, and wherein the first interface 152 is provided for inserting the communication module 17 so that the communication module 17 can be electrically connected to the sub-board 15.

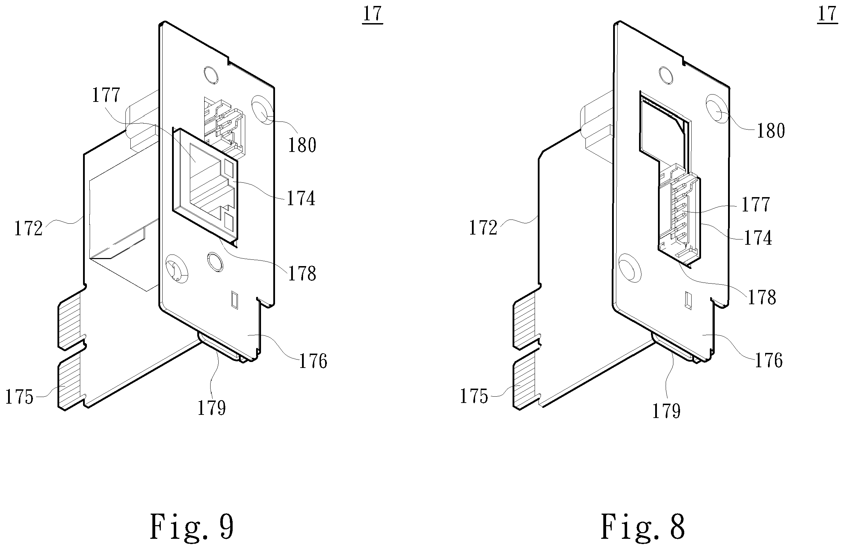

The communication module 17 serves as a main part for the power supply 10 to exchange information with at least one external electronic device (not shown in the figures), and the communication module 17 is used to receive on and off signals of the external electronic device (such as a control computer of the power supply 10), and to return load signals to the external electronic device. The communication module 17 comprises a first circuit board 172 and a communication circuit provided on the first circuit board 172. The communication circuit comprises a second connector 174 for forming an electrical connection with the external electronic device. In one embodiment, a specification of the second connector 174 is selected from a group consisting of RS-232, RS-422, RS-485, CAN bus, Ethernet, LIN bus, I²C, and USB, as shown in FIG. 8 and FIG. 9. Further, the first circuit board 172 comprises an electrical connection part 175 electrically connected to the communication circuit, and the electrical connection part 175 comprises a first state connecting with the first interface 152, and a second state detaching from the first interface 152.

Implementation of the power supply 10 of the invention will be described in detail hereinafter. It is assumed that the communication module 17 is not inserted into the port 111 and is not connected to the first connector 151 initially. When the communication module 17 is arranged to connect to the first connector 151, the electrical connection part 175 is inserted into the first interface 152 and electrically connected to the first connector 151. At this time, the electrical connection part 175 is in the first state, and the communication module 17 is electrically connected to the power conversion circuit via the sub-board 15 so that information can be exchanged between the main board 13 and the communication module 17. When the electrical connection part 175 is detached from the first interface 152, the electrical connection part 175 turns the first state into the second state, in which the communication module 17 is no longer electrically connected to the sub-board 15, the communication module 17 is taken out from the port 111, and there is no structural connection between the sub-board 15 and the communication module 17 via physical wires. That is to say, the communication module 17 is completely separated from the sub-board 15 to be regarded as two independent components at this time.

It can be known from the above that by providing the sub-board 15 and the first connector 151 in the power supply 10 of the invention, the electrical connection part 175 is connected to the first interface 152 when the communication module 17 is inserted into the port 111, and the communication module 17 exchanges information with the main board 13 via the sub-board 15. When a user takes out the communication module 17, the electrical connection part 175 is detached from the first interface 152, and the communication module 17 is disconnected from the sub-board 15 to completely separate from the sub-board 15. Therefore, compared with the prior art, the power supply 10 of the invention has a feature that users can replace the communication module 17 by themselves.

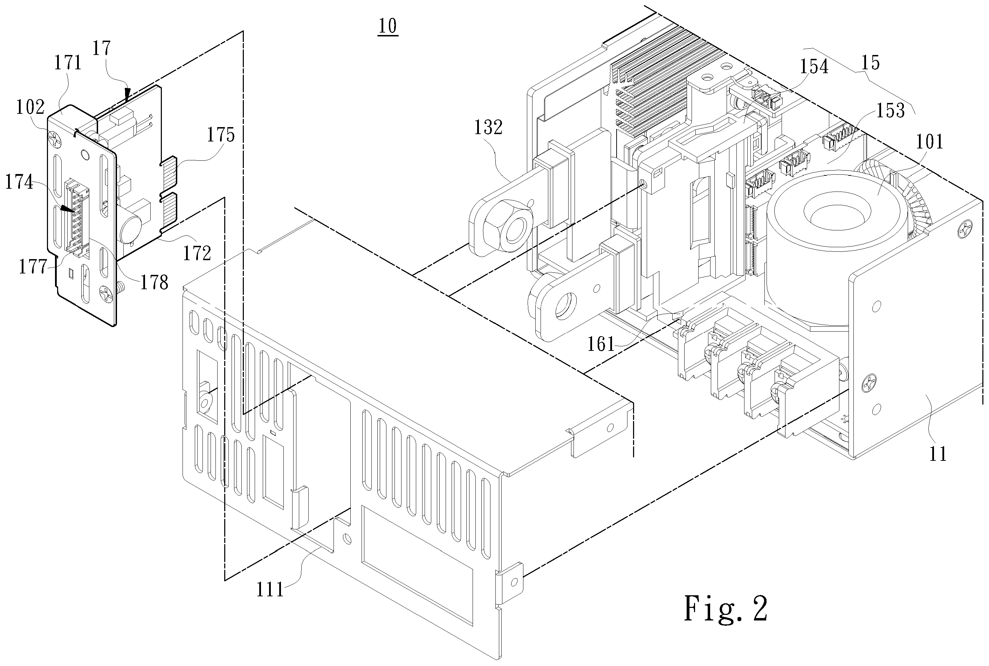

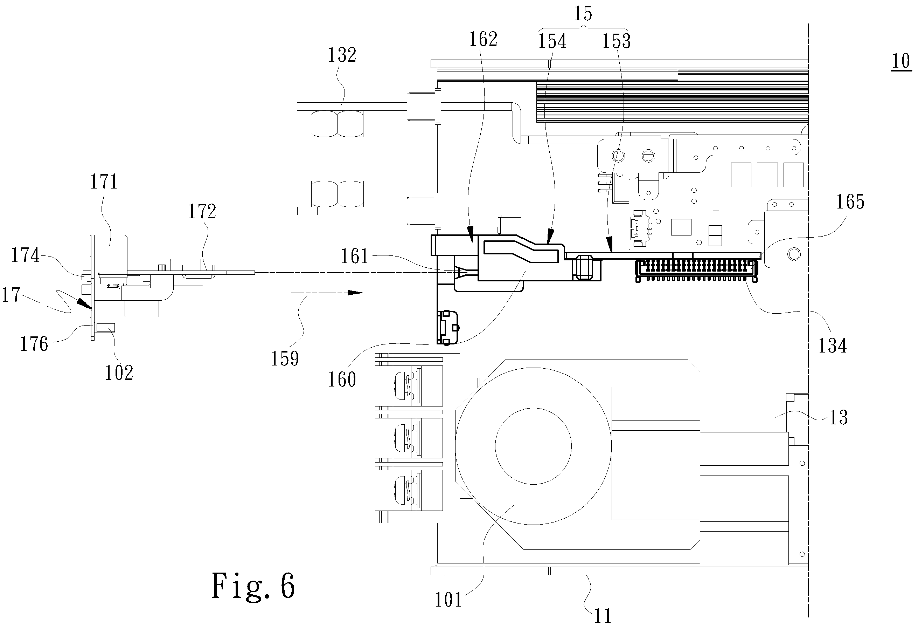

Referring to Figs. 2 to 6, in one embodiment, the sub-board 15 comprises a second circuit board 153 and a socket 154. The second circuit board 153 is electrically connected to the main board 13 and provided with the first connector 151. In addition, the socket 154 is disposed on one side of the second circuit board 153 and assembled with the second circuit board 153. The socket 154 is used to provide a function of positioning the communication module 17 after the communication module 17 is inserted into the port 111. In one embodiment, both the socket 154 and the second circuit board 153 are located in an extending direction 155, and the socket 154 is capable of directly limiting an assembly position of the communication module 17 when the communication module 17 is displaced relative to the first connector 151.

Further, in order to fix the socket 154, the main board 13 comprises at least one assembling hole 133 disposed at a projection position of the socket 154, and the socket 154 comprises at least one positioning protrusion 156. When the positioning protrusion 156 is assembled in the assembling hole 133, a position of the socket 154 on the main board 13 is fixed, and the risk that the socket 154 is collided to be displaced during assembly process of the communication module 17 is reduced. In one embodiment, the positioning protrusion 156 comprises an upright portion 157 and a hook portion 158 connected to the upright portion 157. During assembly process of the socket 154 with the main board 13, the upright portion 157 is inserted into the assembling hole 133, and the hook portion 158 is disposed to hook on the main board 13, such that a position of the socket 154 is fixed on the main board 13 by the hook portion 158. In addition, the hook portion 158 of the invention also provides an effect of limiting the socket 154 to be assembled in a single direction, thereby reducing interference of the electronic components 101 during assembly of the socket 154.

Referring to Figs. 2 to 6, the socket 154 of the invention defines an assembly path 159 for the communication module 17 to be directly plugged into the first connector 151. In more detail, the assembly path 159 is used to limit an assembling direction of the communication module 17 and limit a displacement track of the communication module 17 simultaneously. In this embodiment, the socket 154 comprises two side walls 160 disposed in parallel with each other and two position limiting rails 161 located on the two side walls 160 respectively. The two side walls 160 are respectively located on two opposite sides of the socket 154. When the socket 154 is assembled with the communication module 17, the two side walls 160 are respectively connected with two ends of the first circuit board 172. The two position limiting rails 161 provide a guiding function for the first circuit board 172 so that the user can push or pull the communication module 17 relative to the socket 154 during assembly or disassembly of the communication module 17. In one embodiment, the socket 154 is formed with the positioning protrusion 156 with one of the two side walls 160.

In addition, in order to limit an assembly position of the communication module 17 in the invention, one of the two side walls 160 is formed with a gap 162 at a side close to the port 111, and the gap 162 is provided for inserting a positioning plate 171 of the communication module 17. Furthermore, in order to assist in limiting the communication module 17, in one embodiment, the socket 154 comprises a retaining wall 163 disposed on a side facing the second circuit board 153 and connected to the two side walls 160. The retaining wall 163 limits an assembly position of the first circuit board 172. In addition, the retaining wall 163 is formed with a through hole 164 for assembling the second circuit board 153 so that the second circuit board 153 is stably assembled with the socket 154 by disposal of the through hole 164.

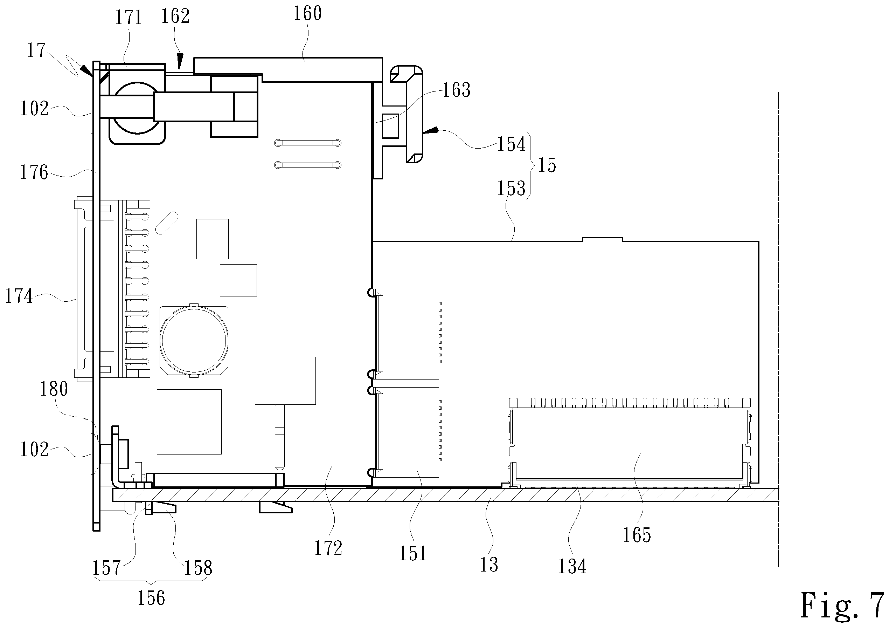

In one embodiment, the electrical connection part 175 may be formed by a plurality of conductive terminals which are commonly called connecting fingers by those having ordinary skill in the art. In addition, the communication module 17 comprises a covering plate 176 connected to the first circuit board 172. The covering plate 176 is disposed at the port 111 and formed with an opening 178 exposed on a surface and communicated to a second interface 177 of the second connector 174. The external electronic device is connected to the second interface 177 through the opening 178 so that the external electronic device can exchange information with the power supply 10. In one embodiment of the invention, in order to assist in positioning the communication module 17, the covering plate 176 comprises an auxiliary positioning plate 179 facing the main board 13 and the socket 154. The auxiliary positioning plate 179 and the positioning plate 171 are respectively located on two opposite sides of the covering plate 176 to position two ends of the covering plate 176. Referring to Figs. 2 to 7, in another embodiment, the covering plate 176 is formed with at least one assembly hole 180 which faces the socket 154 or the casing 11, and the least one assembly hole 180 is assembled with a fixing member 102 to fix an assembly position of the covering plate 176.

On the other hand, in the invention, in order to reduce physical wires inside the power supply 10, the main board 13 and the sub-board 15 are not connected by electric wires. The main board 13 comprises a third connector 134, the sub-board 15 comprises a fourth connector 165, the third connector 134 is electrically connected to the power conversion circuit, the fourth connector 165 is electrically connected to the first connector 151 and assembled with the third connector 134. Accordingly, the sub-board 15 is capable of providing signal transmission between the communication module 17 and the main board 13 via the fourth connector 165.

## Claims

1. A power supply (10), comprising:
a casing (11), comprising a port (111);
a main board (13), disposed in the casing (11) and provided with a power conversion circuit, the power conversion circuit comprising at least one electrical connection terminal (132), wherein the main board (13) comprises at least one assembling hole (133); and
a replaceable communication module (17), configured to receive on and off signals of at least one external electronic device to exchange information therewith, the replaceable communication module (17) comprising a first circuit board (172) and a communication circuit disposed on the first circuit board (172), the communication circuit comprising a second connector (174) for forming an electrical connection with the at least one external electronic device, the first circuit board (172) comprising an electrical connection part (175) electrically connected to the communication circuit;
**characterized in that:**
the power supply (10) comprises a sub-board (15) disposed on the main board (13), wherein
the sub-board (15) comprises at least one first connector (151), a second circuit board (153) and a socket (154), a first interface (152) of each first connector (151) directly facing the port (111),
the second circuit board (153) is provided with the at least one first connector (151) on one side and is electrically connected with the main board (13), and
the socket (154) is configured to position the replaceable communication module (17) when inserted into the port (111), the socket (154) being disposed on the side of the second circuit board (153) with the at least one first connector (151), and the socket (154) and the second circuit board (153) being located in an extending direction (155); and wherein
the socket (154) comprises at least one positioning protrusion (156), two side walls (160) disposed in parallel, two position limiting rails (161) respectively located on the two side walls (160), and a retaining wall (163), wherein
the retaining wall (163) is disposed on a side of the socket (154) facing the second circuit board (153),
the two side walls (160) are respectively located on two opposite sides of the socket (154) without the retaining wall (163) and connected to the retaining wall (163), and
the at least one positioning protrusion (156) is formed on one of the two side walls (160) and assembled in the at least one assembling hole (133) of the main board (13) for fixing the position of the socket (154) on the main board (13); wherein
the replaceable communication module (17) is configured to be assembled in the socket (154), and two sides of the first circuit board (172) are configured to be respectively connected with the two side walls (160), an assembly position of the first circuit board (172) is limited by the retaining wall (163), and the first circuit board (172) is guided by the two position limiting rails (161) so that the replaceable communication module (17) can be displaced relative to the socket (154) to form a first state and a second state of the electrical connection part (175); wherein
in the first state the electrical connection part (175) is connected with the first interface (152) and the replaceable communication module (17) is electrically connected to the power conversion circuit via the sub-board (15), and
in the second state the electrical connection part (175) is detached from the first interface (152) and the replaceable communication module (17) is separated from the sub-board (15) and electrically disconnected from the sub-board (15).

2. The power supply (10) as claimed in claim 1, wherein the positioning protrusion (156) comprises an upright portion (157) and a hook portion (158) connected to the upright portion (157).

3. The power supply (10) as claimed in claim 1 or 2, wherein the socket (154) defines an assembly path (159) for the replaceable communication module (17) to be directly plugged into the at least one first connector (151).

4. The power supply (10) as claimed in claim 1 or 2, wherein the replaceable communication module (17) comprises a positioning plate (171), and wherein the socket (154) comprises two side walls (160) disposed in parallel, and one of the two side walls (160) is formed with a gap (162) at a side close to the port (111) for inserting the replaceable communication module (17).

5. The power supply (10) as claimed in claim 1 or 2, wherein the electrical connection part (175) is formed by a plurality of conductive terminals.

6. The power supply (10) as claimed in claim 1 or 2, wherein a specification of the second connector (174) is selected from a group consisting of RS-232, RS-422, RS-485, CAN bus, Ethernet, LIN bus, I2C, and USB.

7. The power supply (10) as claimed in claim 6, wherein the replaceable communication module (17) comprises a covering plate (176) connected to the first circuit board (172) and disposed at the port (111), and the covering plate (176) is formed with an opening (178) exposed on a surface and communicated to a second interface (177) of the second connector (174).

8. The power supply (10) as claimed in claim 7, wherein the positioning plate (171) is located on the covering plate (176) and is connected to the sub-board (15) to position an assembly position of the replaceable communication module (17).

9. The power supply (10) as claimed in claim 8, wherein the main board (13) comprises a third connector (134) electrically connected to the power conversion circuit, and the sub-board (15) comprises a fourth connector (165) connected to the third connector (134).

10. The power supply (10) as claimed in claim 1 or 2, wherein the replaceable communication module (17) comprises a covering plate (176) connected to the first circuit board (172) and disposed at the port (111), and the covering plate (176) is formed with an opening (178) exposed on a surface and communicated to a second interface (177) of the second connector (174).

11. The power supply (10) as claimed in claim 10, wherein the replaceable communication module (17) comprises a positioning plate (171), and the positioning plate (171) is located on the covering plate (176) and is connected to the sub-board (15) to position an assembly position of the replaceable communication module (17).

12. The power supply (10) as claimed in claim 11, wherein the main board (13) comprises a third connector (134) electrically connected to the power conversion circuit, and the sub-board (15) comprises a fourth connector (165) connected to the third connector (134).

13. The power supply (10) as claimed in claim 1 or 2, wherein the main board (13) comprises a third connector (134) electrically connected to the power conversion circuit, and the sub-board (15) comprises a fourth connector (165) connected to the third connector (134).

## Patentansprüche

1. Stromversorgung (10), umfassend:
ein Gehäuse (11) mit einer Stecköffnung (111);
eine Hauptplatine (13), die in dem Gehäuse (11) angeordnet und mit einer Stromwandlerschaltung versehen ist, wobei die Stromwandlerschaltung mindestens einen elektrischen Anschluss (132) umfasst, wobei die Hauptplatine (13) mindestens ein Montagebohrung (133) umfasst; und
ein austauschbares Kommunikationsmodul (17), das so konfiguriert ist, dass es Ein- und Ausschaltsignale von mindestens einem externen elektronischen Gerät empfängt, um Informationen mit diesem auszutauschen, wobei das austauschbare Kommunikationsmodul (17) eine erste Leiterplatte (172) und eine auf der ersten Leiterplatte (172) angeordnete Kommunikationsschaltung umfasst, wobei die Kommunikationsschaltung einen zweiten Verbinder (174) zum Herstellen einer elektrischen Verbindung mit dem mindestens einen externen elektronischen Gerät umfasst, wobei die erste Leiterplatte (172) einen elektrischen Verbindungsabschnitt (175) umfasst, der elektrisch mit der Kommunikationsschaltung verbunden ist;
**dadurch gekennzeichnet, dass**
die Stromversorgung (10) eine auf der Hauptplatine (13) angeordnete Nebenplatine (15) umfasst, wobei
die Nebenplatine (15) mindestens einen ersten Steckverbinder (151), eine zweite Leiterplatte (153) und eine Buchse (154) umfasst, wobei eine erste Schnittstelle (152) jedes ersten Steckverbinders (151) direkt der Stecköffnung (111) zugewandt ist,
die zweite Leiterplatte (153) auf einer Seite mit dem mindestens einen ersten Steckverbinder (151) versehen und elektrisch mit der Hauptplatine (13) verbunden ist, und
die Buchse (154) so konfiguriert ist, dass diese das austauschbare Kommunikationsmodul (17) beim Einsetzen in die Stecköffnung (111) positioniert, wobei die Buchse (154) auf der Seite der zweiten Leiterplatte (153) mit dem mindestens einen ersten Steckverbinder (151) angeordnet ist und die Buchse (154) und die zweite Leiterplatte (153) in einer Erstreckungsrichtung (155) liegen; und wobei
die Buchse (154) mindestens einen Positionierungsvorsprung (156), zwei parallel zueinander angeordnete Seitenwände (160), zwei Positionsbegrenzungsschienen (161), die jeweils an den beiden Seitenwänden (160) angeordnet sind, und eine Haltewand (163) aufweist, wobei
die Haltewand (163) auf einer der zweiten Leiterplatte (153) zugewandten Seite der Buchse (154) angeordnet ist,
die beiden Seitenwände (160) jeweils an zwei gegenüberliegenden Seiten der Buchse (154) ohne die Haltewand (163) angeordnet und mit der Haltewand (163) verbunden sind, und der mindestens eine Positionierungsvorsprung (156) an einer der beiden Seitenwände (160) ausgebildet und in der mindestens einen Montagebohrung (133) der Hauptplatine (13) montiert ist, um die Position der Buchse (154) auf der Hauptplatine (13) zu fixieren; wobei
das austauschbare Kommunikationsmodul (17) so konfiguriert ist, dass es in die Buchse (154) montiert werden kann, und zwei Seiten der ersten Leiterplatte (172) so konfiguriert sind, dass diese jeweils mit den beiden Seitenwänden (160) verbunden werden können, wobei eine Montageposition der ersten Leiterplatte (172) durch die Haltewand (163) begrenzt ist, und die erste Leiterplatte (172) von den beiden Positionsbegrenzungsschienen (161) geführt ist, so dass das austauschbare Kommunikationsmodul (17) relativ zur Buchse (154) verschoben werden kann, um einen ersten Zustand und einen zweiten Zustand des elektrischen Verbindungsabschnitts (175) zu bilden; wobei
in dem ersten Zustand der elektrische Verbindungsabschnitt (175) mit der ersten Schnittstelle (152) verbunden ist und das austauschbare Kommunikationsmodul (17) über die Nebenplatine (15) elektrisch mit der Stromwandlerschaltung verbunden ist, und
in dem zweiten Zustand der elektrische Verbindungsabschnitt (175) von der ersten Schnittstelle (152) gelöst und das austauschbare Kommunikationsmodul (17) von der Nebenplatine (15) getrennt und elektrisch von der Nebenplatine (15) getrennt ist.

2. Stromversorgung (10) nach Anspruch 1, wobei der Positionierungsvorsprung (156) einen aufrechten Abschnitt (157) und einen mit dem aufrechten Abschnitt (157) verbundenen Hakenabschnitt (158) umfasst.

3. Stromversorgung (10) nach Anspruch 1 oder 2, wobei die Buchse (154) einen Montageweg (159) für das austauschbare Kommunikationsmodul (17) definiert, sodass dieses direkt in den mindestens einen ersten Steckverbinder (151) eingesteckt werden kann.

4. Stromversorgung (10) nach Anspruch 1 oder 2, wobei das austauschbare Kommunikationsmodul (17) eine Positionierungsplatte (171) umfasst, und wobei die Buchse (154) zwei parallel zueinander angeordnete Seitenwände (160) umfasst, und eine der beiden Seitenwände (160) an einer Seite nahe der Stecköffnung (111) zum Einsetzen des austauschbaren Kommunikationsmoduls (17) mit einem Spalt (162) ausgebildet ist.

5. Stromversorgung (10) nach Anspruch 1 oder 2, wobei der elektrische Verbindungsabschnitt (175) durch mehrere elektrisch leitende Anschlüsse ausgebildet ist.

6. Stromversorgung (10) nach Anspruch 1 oder 2, wobei eine Spezifikation des zweiten Steckverbinders (174) aus einer Gruppe ausgewählt ist, die aus RS-232, RS-422, RS-485, CAN-Bus, Ethernet, LIN-Bus, I2C und USB besteht.

7. Stromversorgung (10) nach Anspruch 6, wobei das austauschbare Kommunikationsmodul (17) eine Abdeckplatte (176) umfasst, die mit der ersten Leiterplatte (172) verbunden und an der Stecköffnung (111) angeordnet ist, und wobei die Abdeckplatte (176) mit einer Stecköffnung (178) ausgebildet ist, die an einer Oberfläche freiliegt und mit einer zweiten Schnittstelle (177) des zweiten Steckverbinders (174) in Verbindung steht.

8. Stromversorgung (10) nach Anspruch 7, wobei die Positionierungsplatte (171) auf der Abdeckplatte (176) angeordnet und mit der Nebenplatine (15) verbunden ist, um eine Montageposition des austauschbaren Kommunikationsmoduls (17) zu positionieren.

9. Stromversorgung (10) nach Anspruch 8, wobei die Hauptplatine (13) einen dritten Steckverbinder (134) umfasst, der elektrisch mit der Stromwandlerschaltung verbunden ist, und die Nebenplatine (15) einen vierten Steckverbinder (165) umfasst, der mit dem dritten Steckverbinder (134) verbunden ist.

10. Stromversorgung (10) nach Anspruch 1 oder 2, wobei das austauschbare Kommunikationsmodul (17) eine Abdeckplatte (176) umfasst, die mit der ersten Leiterplatte (172) verbunden und an der Stecköffnung (111) angeordnet ist, und die Abdeckplatte (176) mit einer Stecköffnung (178) ausgebildet ist, die an einer Oberfläche freiliegt und mit einer zweiten Schnittstelle (177) des zweiten Steckverbinders (174) in Verbindung steht.

11. Stromversorgung (10) nach Anspruch 10, wobei das austauschbare Kommunikationsmodul (17) eine Positionierungsplatte (171) umfasst und die Positionierungsplatte (171) auf der Abdeckplatte (176) angeordnet und mit der Nebenplatine (15) verbunden ist, um eine Montageposition des austauschbaren Kommunikationsmoduls (17) zu positionieren.

12. Stromversorgung (10) nach Anspruch 11, wobei die Hauptplatine (13) einen dritten Steckverbinder (134) umfasst, der elektrisch mit der Stromwandlerschaltung verbunden ist, und die Nebenplatine (15) einen vierten Steckverbinder (165) umfasst, der mit dem dritten Steckverbinder (134) verbunden ist.

13. Stromversorgung (10) nach Anspruch 1 oder 2, wobei die Hauptplatine (13) einen dritten Steckverbinder (134) umfasst, der elektrisch mit der Stromwandlerschaltung verbunden ist, und die Nebenplatine (15) einen vierten Steckverbinder (165) umfasst, der mit dem dritten Steckverbinder (134) verbunden ist.

## Revendications

1. Alimentation électrique (10) comprenant :
un boîtier (11) comprenant un orifice (111) ;
une carte mère (13), disposée dans le boîtier (11) et pourvue d'un circuit de conversion de puissance, le circuit de conversion de puissance comprenant au moins une borne de connexion électrique (132), dans laquelle la carte mère (13) comprend au moins un trou d'assemblage (133) ; et
un module de communication remplaçable (17), configuré pour recevoir des signaux de marche et d'arrêt d'au moins un dispositif électronique externe afin d'échanger des informations avec celui-ci, le module de communication remplaçable (17) comprenant une première carte de circuit imprimé (172) et un circuit de communication disposé sur la première carte de circuit imprimé (172), le circuit de communication comprenant un deuxième connecteur (174) pour former une connexion électrique avec le au moins un dispositif électronique externe, la première carte de circuit (172) comprenant une partie de connexion électrique (175) connectée électriquement au circuit de communication ;
**caractérisé en ce que :**
l'alimentation électrique (10) comprend une carte secondaire (15) disposée sur la carte principale (13), dans laquelle
la carte secondaire (15) comprend au moins un premier connecteur (151), une deuxième carte de circuit imprimé (153) et une prise (154), une première interface (152) de chaque premier connecteur (151) est directement en face du port (111),
la deuxième carte de circuit (153) est pourvue d'au moins un premier connecteur (151) sur un côté et est connectée électriquement à la carte principale (13), et
la prise (154) est configurée pour positionner le module de communication remplaçable (17) lorsqu'il est inséré dans le port (111), la prise (154) étant disposée sur le côté de la deuxième carte de circuit imprimé (153) avec le au moins un premier connecteur (151), et la prise (154) et la deuxième carte de circuit imprimé (153) étant situées dans une direction d'extension (155) ; et dans lequel
la prise (154) comprend au moins une saillie de positionnement (156), deux parois latérales (160) disposées parallèlement, deux rails de limitation de position (161) situés respectivement sur les deux parois latérales (160), et une paroi de retenue (163), dans lequel
la paroi de retenue (163) est disposée sur un côté de la douille (154) faisant face à la deuxième carte de circuit imprimé (153),
les deux parois latérales (160) sont respectivement situées sur deux côtés opposés de la douille (154) sans la paroi de retenue (163) et reliées à la paroi de retenue (163), et
la au moins une saillie de positionnement (156) est formée sur l'une des deux parois latérales (160) et assemblée dans le au moins un trou d'assemblage (133) de la carte principale (13) pour fixer la position de la prise (154) sur la carte principale (13) ; dans lequel
le module de communication remplaçable (17) est configuré pour être assemblé dans la prise (154), et les deux côtés de la première carte de circuit imprimé (172) sont configurés pour être respectivement connectés aux deux parois latérales (160), une position d'assemblage de la première carte de circuit imprimé (172) est limitée par la paroi de retenue (163), et la première carte de circuit (172) est guidée par les deux rails de limitation de position (161) de sorte que le module de communication remplaçable (17) peut être déplacé par rapport à la prise (154) pour former un premier état et un deuxième état de la partie de connexion électrique (175) ; dans lequel,
dans le premier état, la partie de connexion électrique (175) est connectée à la première interface (152) et le module de communication remplaçable (17) est connecté électriquement au circuit de conversion de puissance via la sous-carte (15), et
dans le deuxième état, la partie de connexion électrique (175) est détachée de la première interface (152) et le module de communication remplaçable (17) est séparé de la sous-carte (15) et déconnecté électriquement de la sous-carte (15).

2. L'alimentation électrique (10) selon la revendication 1, dans laquelle la saillie de positionnement (156) comprend une partie verticale (157) et une partie en crochet (158) reliée à la partie verticale (157).

3. L'alimentation électrique (10) selon la revendication 1 ou 2, dans laquelle la prise (154) définit un chemin d'assemblage (159) pour le module de communication remplaçable (17) à brancher directement dans le au moins un premier connecteur (151).

4. L'alimentation électrique (10) selon la revendication 1 ou 2, dans laquelle le module de communication remplaçable (17) comprend une plaque de positionnement (171), et dans laquelle la prise (154) comprend deux parois latérales (160) disposées parallèlement, et l'une des deux parois latérales (160) est formée avec un espace (162) sur un côté proche du port (111) pour insérer le module de communication remplaçable (17).

5. L'alimentation électrique (10) selon la revendication 1 ou 2, dans laquelle la partie de connexion électrique (175) est formée par une pluralité de bornes conductrices.

6. L'alimentation électrique (10) selon la revendication 1 ou 2, dans laquelle une spécification du deuxième connecteur (174) est choisie parmi un groupe comprenant RS-232, RS-422, RS-485, bus CAN, Ethernet, bus LIN, I2C et USB.

7. L'alimentation électrique (10) selon la revendication 6, dans laquelle le module de communication remplaçable (17) comprend une plaque de recouvrement (176) connectée à la première carte de circuit imprimé (172) et disposée au niveau du port (111), et la plaque de recouvrement (176) est formée avec une ouverture (178) exposée sur une surface et communiquant avec une deuxième interface (177) du deuxième connecteur (174).

8. L'alimentation électrique (10) selon la revendication 7, dans laquelle la plaque de positionnement (171) est située sur la plaque de recouvrement (176) et est connectée à la carte secondaire (15) pour positionner une position d'assemblage du module de communication remplaçable (17).

9. L'alimentation électrique (10) selon la revendication 8, dans laquelle la carte principale (13) comprend un troisième connecteur (134) connecté électriquement au circuit de conversion de puissance, et la carte secondaire (15) comprend un quatrième connecteur (165) connecté au troisième connecteur (134).

10. L'alimentation électrique (10) selon la revendication 1 ou 2, dans laquelle le module de communication remplaçable (17) comprend une plaque de recouvrement (176) connectée à la première carte de circuit imprimé (172) et disposée au niveau du port (111), et la plaque de recouvrement (176) est formée avec une ouverture (178) exposée sur une surface et communiquant avec une deuxième interface (177) du deuxième connecteur (174).

11. L'alimentation électrique (10) selon la revendication 10, dans laquelle le module de communication remplaçable (17) comprend une plaque de positionnement (171), et la plaque de positionnement (171) est située sur la plaque de recouvrement (176) et est connectée à la carte secondaire (15) afin de positionner une position d'assemblage du module de communication remplaçable (17).

12. L'alimentation électrique (10) selon la revendication 11, dans laquelle la carte principale (13) comprend un troisième connecteur (134) connecté électriquement au circuit de conversion de puissance, et la carte secondaire (15) comprend un quatrième connecteur (165) connecté au troisième connecteur (134).

13. L'alimentation électrique (10) selon la revendication 1 ou 2, dans laquelle la carte principale (13) comprend un troisième connecteur (134) connecté électriquement au circuit de conversion de puissance, et la carte secondaire (15) comprend un quatrième connecteur (165) connecté au troisième connecteur (134).
